# EUROPÄISCHE PATENTSCHRIFT

(11) **EP 1 481 479 B1**
(45) Veröffentlichungstag und Bekanntmachung des Hinweises auf die Patenterteilung: **06.09.2006**
(21) Anmeldenummer: 03743338.0
(22) Anmeldetag: 26.02.2003
(51) Int. Cl.: H03M 7/30, G06F 13/38

(54) **VERFAHREN UND VORRICHTUNG ZUM REDUZIEREN EINER ZU ÜBERTRAGENDEN DATENMENGE VON PROZESSDATEN**
METHOD AND DEVICE FOR REDUCING A DATASET CONSISTING OF PROCESS DATA TO BE TRANSMITTED
PROCEDE ET DISPOSITIF PERMETTANT DE REDUIRE UNE QUANTITE DE DONNEES DE TRAITEMENT A TRANSMETTRE

(30) Priorität: 06.03.2002 DE 10209734
(43) Veröffentlichungstag der Anmeldung: 01.12.2004
(73) Patentinhaber: Endress + Hauser GmbH + Co. KG, 79689 Maulburg (DE); Endress + Hauser (Deutschland) Holding GmbH, 79576 Weil am Rhein (DE)
(72) Erfinder: THOREN, Werner, 79585 Steinen (DE)
(74) Vertreter: Andres, Angelika Maria
(86) Internationale Anmeldenummer: PCT/EP2003/001956
(87) Internationale Veröffentlichungsnummer: WO 2003/075466

(56) Entgegenhaltungen:
- EP-B- 0 875 023
- WO-A-00/69116
- DE-A- 4 300 661
- US-B1- 6 215 907

## Beschreibung

Die Erfindung bezieht sich auf ein Verfahren zum Reduzieren einer von einem Feldgerät zu übertragenden Datenmenge von Prozessdaten gemäss Oberbegriff des Anspruchs 1 und eine Vorrichtung zur Durchführung des Verfahrens gemäss Oberbegriff des Anspruchs 12.

In der Automatisierungstechnik werden heute Feldgeräte eingesetzt, die zur Erfassung und/oder Beeinflussung von Prozessvariablen dienen. Beispiele für derartige Feldgeräte zur Erfassung von Prozessvariablen sind Füllstandmessgeräte, Massedurchflussmesser, Druckmesser, Temperaturmesser etc., die die entsprechenden Prozessvariablen Füllstand, Massedurchfluss, Druck bzw. Temperatur erfassen. Beispiele für Feldgeräte zur Beeinflussung von Prozessvariablen sind sogenannte Aktoren, die z.B. als Ventile den Durchfluss einer Flüssigkeit in einem Rohrleitungsabschnitt oder als Pumpen den Füllstand eines Mediums in einem Behälter steuern.

Die Feldgeräte sind über entsprechende Kommunikationsverbindungen, in der Regel über einen Datenbus, mit einer Prozessleitzentrale verbunden, die den gesamten Prozessablauf steuert bzw. einen direkten Zugriff zum Bedienen, Parametrieren oder Konfigurieren auf die einzelnen Feldgeräte ermöglicht. Durch den direkten Zugriff können Einstellungen (z.B. Parameter) am Feldgerät geändert werden oder spezielle Diagnosefunktionen aufgerufen werden. Neben dem Zugriff über die Prozessleitzentrale ist auch ein zeitweiliger Zugriff, z.B. über ein tragbares Handbediengerät (Handheld), tragbarer Rechner oder ein Handy möglich.

Um die Bedienung verschiedener Feldgeräte von der Prozessleitzentrale zu ermöglichen, muss der Prozessleitzentrale die Funktionalität des Feldgerätes bekannt sein. Die Funktionalität eines Feldgerätes wird normalerweise mittels einer Gerätebeschreibung beschrieben. Hierfür stehen spezielle standardisierte Gerätebeschreibungssprachen zur Verfügung; Beispiele sind CAN - EDS (Control Aria Network - Electronic Data Sheet), Hart - DDL (Hart - Device Description Language), FF - DDL (Fieldbus Foundation - Device Description Language), Profibus - GSD (Profibus - Gerätestammdaten), Profibus - EDD (Profibus - Electronic Device Description). Von der Prozessleitzentrale erfolgt die Bedienung des Feldgerätes meist über eine grafische Bedienoberfläche, die die Inbetriebnahme, Wartung, Datensicherung, Problembehebung und Gerätedokumentation erleichtert.

In der Prozessleitzentrale werden die Messwerte der verschiedenen Prozessvariablen ausgewertet bzw. überwacht und die entsprechenden Aktoren angesteuert.

Die Datenübertragung zwischen dem Feldgerät und der Prozessleitzentrale erfolgt drahtgebunden oder drahtlos nach einem der bekannten internationalen Standards für Feldbusse, wie z.B. Hart, Foundation Fieldbus, Profibus, CAN etc. oder für entfernt angeordnete Anlagenteile über öffentliche Kommunikationsnetze.

Bei einem von der Prozessleitzentrale gesteuerten Prozess, der auf mehrere Standorte verteilt ist und/oder der eine Vielzahl von Feldgeräten umfasst, kann die zu übertragende Datenmenge zu einer Überlastung der Datenbussysteme bzw. die öffentlichen Netze können zu lange in Anspruch genommen werden. Aus das US 6 215 907 ist ein gattungsgemäßes Verfahren bekannt bei dem der Datenmenge durch eine aufwendigen Wavelet-Transformation reduziert wird.

Aufgabe der Erfindung ist es deshalb, ein Verfahren und ein Vorrichtung zur Reduzierung einer zu übertragenden Datenmenge von Prozessdaten anzugeben.

Diese Aufgabe wird erfindungsgemäß bezüglich des Verfahrens durch die Merkmale des Anspruchs 1 und bezüglich der Vorrichtung durch die Merkmale des Anspruchs 11 gelöst. Die abhängigen Ansprüche betreffen vorteilhafte Aus- und Weiterbildungen der Erfindung.

Der Hauptgedanke der Erfindung besteht darin, dass die in einem intervall zwischen zwei Datenübertragungen anfallenden Prozessdaten gespeichert und bewertet werden, wobei die bewerteten Prozessdaten an eine Prozessleitstelle übertragen werden. Die Prozessdaten umfassen informationen über die Betriebszustände der Feldgerät und/oder Informationen über die Prozessvariablen, die mit den Feldgeräten erfasst werden und/oder Identifikationsdaten des jeweiligen Feldgerates. Unter dem Begriff Feldgerät werden dabei auch Aktoren zur Beeinflussung der Prozessvariablen verstanden.

Eine Reduzierung der zu übertragenden Prozessdaten wird durch die Bewertung der Prozessdaten erreicht. Bei der Bewertung werden die Prozessdaten in statische und dynamische Daten eingeteilt. Alle Prozessdaten, die sich seit der letzten durchgeführten Bewertung verändert haben, werden als, dynamische Daten klassifiziert. Alle Prozessdaten, die sich seit der letzten Bewertung nicht verändert haben, werden als statische Daten klassifiziert und als binärer Zustandswert übertragen, wobei die Prozessleitzentrale an dem übertragenen Zustandswert erkennt, dass keine Veränderung der zugehörigen Prozessgröße vorliegt.

Typische dynamische Daten sind beispielsweise die Messwerte der mit dem Feldgerät überwachten Prozessvariablen wie Füllstand, Massedurchfluss, Druck bzw. Temperatur. Typische statische Daten, die sich über einen längeren Zeitraum nicht ändern; sind beispielsweise der aktuelle Gerätezustand (alles in Ordnung, bzw. ein Fehlercode), die Art der überwachten Prozessvariable und/oder die physikalische Einheit des ermittelten Messwertes. Bei der Inbetriebnahme der Anlage werden einmalig alle Prozessdaten unbewertet an die Prozesszentrale übertragen. Anschließend werden die Prozessdaten vor der Übertragung bewertet und die statischen Daten nur noch als binäre Zustandswert übertragen. Dadurch lässt sich in vorteilhafter Weise der Umfang der zu übertragenden Prozessdaten reduzieren, da nur noch die dynamischen Daten als ein ausführliches Datenwort übertragen werden müssen.

Eine weitere Reduzierung der statischen Daten wird bei einer Weiterbildung der Erfindung dadurch erreicht, dass bestimmte statische Daten wie beispielsweise die Art der überwachten Prozessvariablen und/oder die physikalische Einheit des zu ermittelnden Messwertes in einer Gerätebeschreibungsdatei abgelegt sind. Auf diese Gerätebeschreibungsdatei hat die Prozessleitzentrale einen direkten Zugriff, so dass die entsprechenden Daten nicht vom Feldgeräte an die Prozessleitzentrale übertragen werden müssen.

Eine zusätzliche Reduzierung der zu übertragenden Prozessdaten wird in vorteilhafter Weise dadurch erreicht, dass die Anzahl der Datenübertragungen reduziert wird. Zu diesem Zweck wird die Übertragung der reduzierten Prozessdaten vom Eintreten von vorgegebenen Bedingungen abhängig gemacht.

Die zu übertragende Datenmenge lässt sich weiter reduzieren, wenn bei der Übertragung der dynamischen Daten nur der Differenzwert zwischen dem aktuellen und dem alten Wert der Prozessvariablen übertragen wird. Zur Vermeidung von Fehlerfortschreibungen kann in vorteilhafter Weise vorgesehen werden, dass regelmäßig, beispielsweise einmal am Tag oder nach einer vorgebbaren Anzahl von Übertragungen, der aktuelle Wert der Prozessvariablen übertragen wird.

Eine weitere Möglichkeit zur Reduzierung der zu übertragenden Daten besteht darin, bei der Bewertung festzustellen, ob die ermittelten Werte der betroffenen Prozessvariablen innerhalb eines vorgegebenen Wertebereichs liegen. Die Bereichsgrenzen können bei einer vorteilhaften Ausgestaltung ebenfalls vom Benutzer vorgegeben werden. Für die Übertragung werden die Bereiche codiert und nur der Code für den betroffenen Bereich in dem der ermittelte Messwert liegt wird an die Prozessleitstelle übertragen. Durch diese Maßnahme können in vorteilhafter Weise die dynamischen Daten durch geschickte Festlegung der Bereiche in statische Daten umgewandelt werden und somit die zu übertragende Datenmenge weiter reduziert werden.

Bei einer besonders vorteilhaften Ausführungsform der Erfindung sind Vorgaben für die Bewertung der Prozessdaten und/oder für die Durchführung der Übertragung der reduzierten Prozessdaten von einem Benutzer beeinflussbar.

Bei einer vorteilhaften Ausführung der Erfindung umfassen die vorgegebenen Bedingungen zum Auslösen einer Datenübertragung als Vorgaben beispielsweise eine bestimmte Zeitspanne und/oder eine vorgegebene Uhrzeit. Zudem können die Vorgaben auch durch das Eintreten von bestimmten Ereignissen, wie beispielsweise das Erreichen und/oder Überschreiten von vorgegebenen Schwellwerten bzw. Alarmkriterien umfassen. Dadurch wird die Anzahl der Datenübertragungen und somit die Datenmenge reduziert.

Durch die Reduzierung der zu übertragenden Datenmenge werden insbesondere die Kosten für die Benutzung der Telefonnetze (Festnetz bzw. Funknetze) gesenkt.

Bei einer vorteilhaften Weiterbildung des Verfahrens sind alle für ein Feldgerät möglichen vom Benutzer beeinflussbaren Vorgaben in einer individuellen zum Feldgerät gehörenden Gerätebeschreibungsdatei abgelegt. Die Gerätebeschreibungsdatei beschreibt zudem die Funktionalität des zugehörigen Feldgerätes und umfasst beispielsweise auch Angaben über die Prozessvariablen, die mit dem Feldgerät ermittelt und/oder beeinflusst werden können und die als statische Daten sonst vom Feldgerät an die Prozessleitzentrale übertragen werden. Mittels der Identifikationsdaten ist dem Feldgerät seine individuelle Gerätebeschreibungsdatei zugeordnet.

Die Datenübertragung zwischen dem Feldgerät und der Prozessleitstelle erfolgt über einen lokalen Datenbus und/oder eine Fernverbindung.

Bei einer besonders vorteilhafte Ausführungsform der Erfindung, wird zwischen dem Feldgerät und der Prozessleitstelle das Internet als Kommunikationsplattform verwendet.

Bei einer weiteren Ausführungsform der Erfindung ist die Datenübertragung zwischen dem Feldgerät und der Prozessleitstelle unidirektional, wobei dann, wenn Daten von der Prozessleitstelle an das Feldgerät übertragen werden müssen, eine bidirektionale Kommunikation durchgeführt wird.

Diese Maßnahme ist insbesondere für Standorte wichtig, beispielsweise in abgelegenen großen Lagerstätten, an denen das Feldgerät zur Energieeinsparung normalerweise abgeschaltet ist und nur bei Vorliegen von vorgegebenen Bedingungen, beispielweise bei Ablauf einer bestimmten Zeitspanne oder zu bestimmten Uhrzeiten, aktiviert wird. Nach der Aktivierung ermittelt das Feldgerät die Prozessdaten die anschließend bewertet, gespeichert und an die Prozessleitzentrale übertragen werden. Anschließend bleibt das Feldgerät für eine vorbestimmte Zeitspanne aktiviert und schaltet sich nach Ablauf der Zeitspanne wieder ab. Die Prozessleitzentrale überprüft in dieser Zeitspanne nach Erhalt der Prozessdaten, ob neue Daten, beispielsweise geänderte Bedingungen zur Auslösung einer Datenübertragung, an das Feldgerät übertragen werden müssen. Werden keine solchen neuen Daten von der Prozessleitzentrale an das Feldgerät übertragen, schaltet sich das Feldgerät nach der vorgegebenen Zeitspanne wieder ab.

Zur Durchführung des erfindungsgemäßen Verfahrens ist eine Auswerte/Steuereinheit vorgesehen, wobei die Auswerte/Steuereinheit in einem Intervall zwischen zwei Datenübertragungen die ermittelten Prozessdaten bewertet und in einer Speichereinheit abspeichert, wobei die Speichereinheit Teil der Auswerte/Steuereinheit sein kann, und wobei die Auswerte/Steuereinheit aus den bewerteten Prozessdaten die zu übertragenden Prozessdaten bildet und mittels entsprechender Kommunikationseinrichtungen an die Prozessleitzentrale überträgt. Zur Eingabe von vorgebbaren Bedingungen durch den Benutzer sind bei einer vorteilhaften Ausführungsform entsprechende Bedien- und Anzeigeeinheiten vorgesehen, die beispielsweise in der Prozessleitzentrale angeordnet sind.

Bei einer anderen vorteilhaften Ausführungsform der Erfindung, ist die Auswerte/Steuereinheit und die Speichereinheit als Teil eines Feldgerätes realisiert.

Nachfolgend ist die Erfindung anhand eines in der Zeichnung dargestellten Ausführungsbeispiels näher erläutert.

Es zeigen
- Fig. 1:: schematische Darstellung einer verteilten Automatisierungsanlage;
- Fig. 2:: schematische Darstellung eines Flussdiagramms des erfindungsgemäßen Verfahrens.

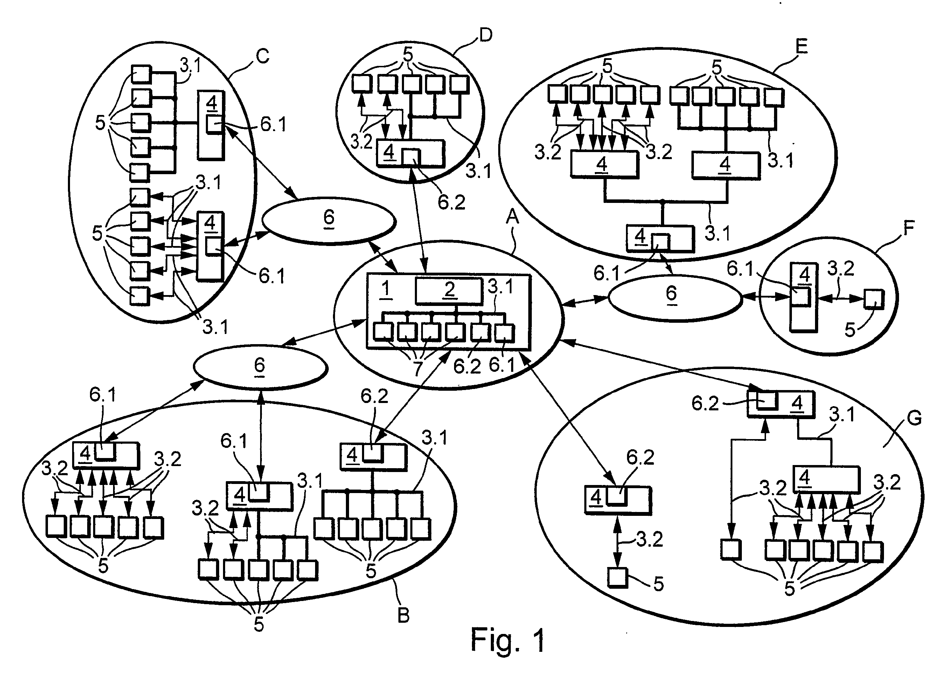

Wie aus Fig. 1 ersichtlich ist, ist die dargestellte Automatisierungsanlage über sieben Standorte A, B, C, D, E, F, G verteilt. An den einzelnen Standorten laufen Teilprozesse ab, die Teil eines standortübergreifenden Prozesses, beispielsweise eines Lagerüberwachungs- bzw. Lageroptimierungsprozess oder eines Produktionsüberwachungs- bzw. Produktionsoptimierungsprozess sind. Bei den Teilprozessen kann es sich um Bedien- und/oder Anzeigeprozesse und/oder um Steuer und/oder Regelprozesse und/oder um Kommunikationsprozesse und/oder um Speicherprozesse und/oder um Prozesse zur Messung und/oder Ermittlung von Prozessvariablen und/oder um Prozesse zur Beeinflussung von Prozessvariablen handeln.

Wie aus Fig. 1 weiter ersichtlich ist, ist am Standort A eine Prozessleitzentrale 1 mit mindestens einem Rechner 2, einer ersten Schnittstelle 6.1 zur Datenübertragung über das Internet 6, einer zweiten Schnittstelle 6.2 zur Datenübertragung über ein Telefonnetz (Festnetz oder Funknetz) und mehrere Bedien- und Anzeigeeinheiten 7, mit denen ein Benutzer unter anderem seine Vorgaben für die Reduzierung der zu übertragenden Prozessdaten eingeben kann. Die einzelnen Einheiten kommunizieren im dargestellten Ausführungsbeispiel über einen lokalen Datenbus 3.1 miteinander. An den anderen Standorten B, C, D, E, F, G ist wenigstens ein Feldgerät 5, wenigstens eine Auswerte/Steuereinheit 4 und wenigstens eine Schnittstelle 6.1, 6.2 zur Kommunikation mit der Prozessleitzentrale 1 vorhanden, wobei die Schnittstelle als Schnittstelle 6.1 zur Datenübertragung über das Internet 6 und/oder als Schnittstelle 6.2 zur Datenübertragung über ein Telefonnetz ausgeführt sein kann. Die dargestellten Standorte zeigen beispielhaft verschiedene Möglichkeiten, wie die mit den Feldgeräten 5 ermittelten oder beeinflussten Prozessgrößen zur Prozessleitzentrale 1 gelangen. So sind am Standort B beispielsweise drei Gruppen von Feldgeräten 5 dargestellt, wobei jeweils fünf Feldgeräte 5 mit einer Auswerte/Steuereinheit 4 verbunden sind, wobei eine erste Gruppe über einen lokalen Datenbus 3.1 mit der zugehörigen Auswerte/Steuereinheit 4 verbunden ist, wobei eine zweite Gruppe von Feldgeräten 5 über einzelne Datenleitungen 3.2 mit der zugehörigen Auswerte/Steuereinheit 4 verbunden ist und wobei bei einer dritten Gruppe drei Feldgeräte 5 über einen lokalen Datenbus 3.1 und zwei Feldgeräte über einzelne Datenleitungen 3.2 mit der zugehörigen Auswerte/Steuereinheit 4 verbunden ist. Für den Datenaustausch mit der Prozessleitzentrale 1 sind am Standort B zwei Auswerte/Steuereinheiten 4 mit einer ersten Schnittstelle 6.1 zur Datenübertragung über das Internet 6 ausgerüstet und eine Auswerte/Steuereinheit 4 ist mit einer zweiten Schnittstelle 6.2 zur Datenübertragung über ein Telefonnetz ausgerüstet.

Es ist aber auch vorstellbar wie die Darstellung des Standorts F zeigt, dass an einem Standort nur ein Feldgerät 5 mit einer Auswerte/Steuereinheit 4 und entsprechender Schnittstelle 6.1 vorhanden ist.

Zudem zeigt die Darstellung des Standorts E, dass nicht jede Auswerte/Steuereinheit 4 über eine Schnittstelle 6.1, 6.2 zur Datenübertragung mit der Prozessleitzentrale 1 ausgerüstet sein muss. Es besteht vielmehr auch die Möglichkeit, dass mehrere Feldgeräte 5 gruppiert und jeweils einer Auswerte/Steuereinheit 4 zugeordnet sind, wobei eine weitere Auswerte/Steuereinheit 4 vorhanden ist, die mit einer Schnittstelle 6.1 zum Datenaustausch mit der Prozessleitzentrale 1 ausgerüstet ist.

Im dargestellten Ausführungsbeispiel sind zwar alle Auswerte/Steuereinheiten 4 als eigenständige Geräte ausgeführt, es ist aber grundsätzlich möglich, dass die Auswerte/Steuereinheit Teil eines Feldgerätes 5 ist. Dies gilt auch für die dargestellten Schnittstellen 6.1, 6.2 zum Datenaustausch mit der Prozessleitzentrale.

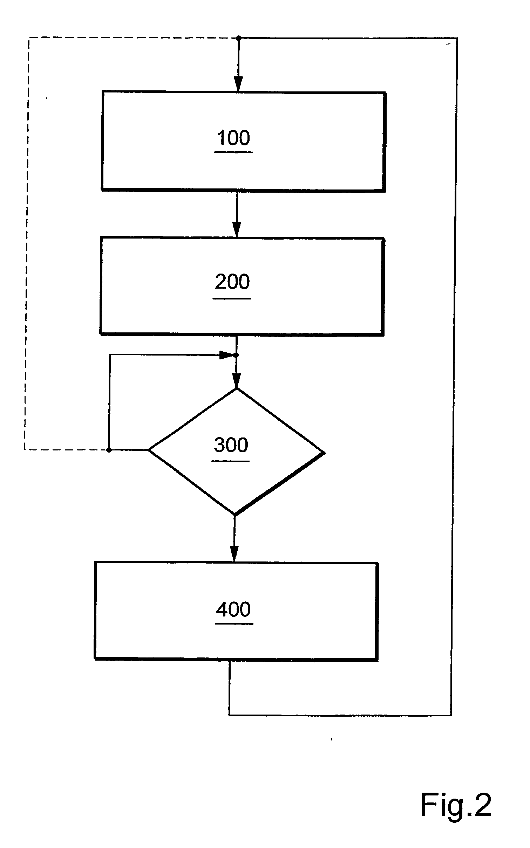

Wie aus der Fig. 2 ersichtlich ist, werden in einem ersten Verfahrensschritt 100 die Prozessdaten ermittelt. Anschließend werden in einem zweiten Verfahrensschritt 200 die Prozessdaten bewertet und gespeichert, wobei nach der Bewertung ein reduzierte zu übertragende Prozessdaten vorliegen. In einem dritten Verfahrensschritt 300 wird überprüft, ob bestimmte vorgegebenen Bedingungen vorliegen, beispielsweise Ablauf einer vorgegebenen Zeitspanne oder Vorliegen eines Alarmkriteriums oder Erreichen eines bestimmten Schwellwertes oder einer bestimmten Uhrzeit. Sind die Vorgaben erfüllt, so werden in einem vierten Verfahrensschritt 400 die bewerteten und reduzierten Prozessdaten an die Prozessleitstelle übertragen. Sind die Vorgaben nicht erfüllt, so wird abhängig vom Prozess entweder zum Verfahrensschritt 100 zurückgesprungen (gestrichelt dargestellt) oder der Verfahrensschritt 300 solange wiederholt, bis die Vorgaben erfüllt sind. Nach dem vierten Verfahrensschritt 400 beginnt das Verfahren mit dem ersten Verfahrensschritt 100 von vorne.

Bei einer weiteren nicht dargestellten Ausführungsform der Erfindung, insbesondere wenn die vorgegebenen Bedingungen zur Übertragung der Prozessdaten nicht von den zu ermittelnden Prozessvariablen abhängt, sondern beispielsweise von einer vorgegebenen Uhrzeit oder Zeitspanne, wird der Verfahrensschritt 300 zuerst ausgeführt und überprüft ob die vorgegebenen Bedingungen erfüllt sind oder nicht und dann, wenn die Bedingungen erfüllt sind, werden im Verfahrensschritt 100 die Prozessdaten ermittelt, im Verfahrensschritt 200 bewertet und gespeichert und dann im Verfahrensschritt 400 an die Prozessleitstelle übertragen. Nach dem Verfahrensschritt 400 wird bei dieser Ausführungsform zum Verfahrensschritt 300 zurückgesprungen und das Verfahren startet von vorne.

## Patentansprüche

1. Verfahren zum Reduzieren einer von einem Feldgerät zu übertragenden Datenmenge von Prozessdaten, wobei die Prozessdaten Informationen über einen Betriebszustand des Feldgerätes und/oder Informationen über mit dem Feldgerät erfasste Prozessvariable und/oder Identifikationsdaten des Feldgerätes umfassen, wobei die in einem intervall zwischen zwei Datenübertragungen anfallenden Prozessdaten bewertet und gespeichert werden, wobei die Prozessdaten durch die Bewertung reduziert werden, und wobei die reduzierten Prozessdaten an eine Prozessleitstelle übertragen werden, **dadurch gekennzeichnet, dass** die Prozessdaten bei der Bewertung in statische und dynamische Daten eingeteilt werden, wobei Prozessdaten, die sich seit der letzten durchgefürhrten Bewertung verändert haben als dynamische Daten klassifiziert werden und dass statische Daten als binärer Zustandswert, des anzeigt, daß keine Anderung des zugeordneten Prozessgröße erfolgt ist, übertragen werden.

2. Verfahren nach Anspruch 1,
**dadurch gekennzeichnet,**
**dass** die Übertragung der reduzierten Prozessdaten nur bei Eintreten von vorgegebenen Bedingungen durchgeführt wird.

3. Verfahren nach einem der vorhergehenden Ansprüche,
**dadurch gekennzeichnet,**
**dass** die Prozessdaten bei der Bewertung in statische und dynamische Daten eingeteilt werden, wobei Prozessdaten die sich seit der letzten durchgeführten Bewertung verändert haben als dynamische Daten klassifiziert werden.

4. Verfahren nach Anspruch 3,
**dadurch gekennzeichnet,**
**dass** für die dynamischen Daten codierte Bereiche vorgegeben sind, wobei nur der Code des betroffenen Bereichs in dem die Prozessgröße enthalten ist an die Prozessleitzentrale übertragen wird.

5. Verfahren nach Anspruch 3 oder 4,
**dadurch gekennzeichnet,**
**dass** statische Daten als binärer Zustandswert übertragen werden.

6. Verfahren nach Anspruch 3,
**dadurch gekennzeichnet,**
**dass** aus den dynamischen Daten ein zu übertragendes Datenwort gebildet wird, wobei das Datenwort den geänderten Wert der Prozessgröße oder den Differenzwert zwischen dem neuen und dem alten Wert der Prozessgröße repräsentiert.

7. Verfahren nach einem der vorhergehenden Ansprüche,
**dadurch gekennzeichnet,**
**dass** die Vorgaben für die Bewertung der Prozessdaten und/oder für die Durchführung der Übertragung der reduzierten Prozessdaten von einem Benutzer beeinflussbar sind.

8. Verfahren nach Anspruch 7,
**dadurch gekennzeichnet,**
**dass** die Vorgaben zur Übertragung der reduzierten Prozessdaten eine vorbestimmten Zeitspanne und/oder eine vorgegebene Uhrzeit und/oder das Eintreten von vorgegebenen Ereignissen umfassen.

9. Verfahren nach einem der vorherigen Ansprüche,
**dadurch gekennzeichnet,**
**dass** dem Feldgerät mittels identifikationsdaten eine individuelle Gerätebeschreibungsdatei zugeordnet wird, wobei informationen uber das Feldgerat aus der Gerätebeschreibungsdatei ausgelesen werden.

10. Verfahren nach einem der vorhergehenden Ansprüche,
**dadurch gekennzeichnet,**
**dass** als Kommunikationsplattform zwischen dem Feldgerät und der Prozessleitstelle das Internet verwendet wird.

11. Vorrichtung zur Reduzierung einer zu übertragenden Datenmenge von Prozessdaten, wobei die Prozessdaten Informationen über einen Betriebszustand eines Feldgerätes und/oder Informationen über mit dem Feldgerät erfasste Prozessvariable und/oder Identifikationsdaten des Feldgerätes umfassen,
**dadurch gekennzeichnet,**
**dass** eine Auswerfe/Steuereinheit und eine Speichereinheit vorgesehen sind, wobei die Auswerte/Steuereinheit in einem Intervall, zwischen zwei Datenübertragungen die ermittelten Prozessdaten bewertet und in der Speichereinheit abspeichert, und mittels entsprechender Kommunikationseinheiten an eine Prozessleitzentrale überträgt. und dass das Feldgerät zum Durchführung des Verfahrens nach einem der Ansprüche 1-10 ausgelegt ist.

12. Vorrichtung nach Anspruch 11,
**dadurch gekennzeichnet,**
**dass** die Auswerte/Steuereinheit und die Speichereinheit Teil eines Feldgerätes sind.

13. Vorrichtung nach Anspruch 11 oder 12,
**dadurch gekennzeichnet,**
**dass** vom Benutzer beeinflussbaren Vorgaben mittels einer Bedien- und Anzeigeeinheit eingegeben werden.

## Claims

1. Method for reducing an amount of process data to be transferred from a field device, wherein the process data include information concerning the operating condition of the field device, and/or information concerning process variables registered with the field device, and/or identification data of the field device,
**characterized in that**,
the process data occurring during an interval between two transfers of data is evaluated and stored, wherein the process data are reduced by means of the evaluation, and wherein the reduced process data are transferred to a process control center, **characterized in that** the process data are split into static and dynamic data during the evaluation, whereby process data that have changed since the last evaluation are classified as dynamic data and process data that have not changed since the last evaluation are classified as static data, and **in that** static data are transmitted in a reduced form as a binary status value that indicates that no change has been made to the assigned process variable.

2. Method as claimed in Claim 1,
**characterized in that**,
the transfer of the reduced process data is executed only at the occurrence of specified conditions.

3. Method as claimed in one of the preceding Claims,
**characterized in that**,
in the evaluating, the process data are divided into static and dynamic data, wherein process data which have changed since the last executed evaluating are classified as dynamic data.

4. Method as claimed in Claim 3,
**characterized in that**,
for the dynamic data, coded ranges are specified, wherein only the code of the affected range, in which the process parameter is contained, is transferred to the process control center.

5. Method as claimed in Claim 3 or 4,
**characterized in that**,
static data are transferred as binary state-values.

6. Method as claimed in Claim 3,
**characterized in that**,
from the dynamic data, a data word to be transferred is formed, wherein the data word represents the altered value of the process parameter, or the difference between the new value and the old value of the process parameter.

7. Method as claimed in one of the preceding Claims,
**characterized in that**,
the specifications for the evaluating of the process data, and/or for the execution of the transfer of the reduced process data, can be influenced by a user.

8. Method as claimed in Claim 7,
**characterized in that**,
the specifications for the transfer of the reduced process data include a predetermined time span, and/or a specified time on the clock, and/or the occurrence of specified events.

9. Method as claimed in one of the preceding Claims,
**characterized in that**,
an individual device description file is assigned to the field device by means of identification data, wherein information concerning the field device is read out of the data description file.

10. Method as claimed in one of the preceding claims,
**characterized in that**,
the Internet is used as communication platform between the field device and the process control station.

11. Apparatus for reducing an amount of process data to be transferred, wherein the process data includes information concerning an operating condition of a field device, and/or information concerning process variables registered with the field device, and/or identification data of the field device,
**characterized in that**,
an evaluation/control unit and a storage unit are provided, wherein the evaluation/control unit, during an interval between two transfers of data, evaluates and stores the acquired process data in the storage unit, and, by means of suitable communication units, transfers such process data to a process control center and that the field device is designed to perform the process as per one of the Claims 1-10.

12. Apparatus as claimed in Claim 11,
**characterized in that**,
the evaluation/control unit and the storage unit are part of a field device.

13. Apparatus as claimed in Claim 11 or 12,
**characterized in that**,
the specifications which can be influenced by the user are entered by means of an operating- and display-unit.

## Revendications

1. Procédé destiné à la réduction d'une quantité de données process à transmettre par un appareil de terrain, les données process concernant des informations sur un état de fonctionnement de l'appareil de terrain et/ou des informations sur des variables process déterminées avec l'appareil de terrain et/ou des données d'identification de l'appareil de terrain, les données process qui s'accumulent dans l'intervalle entre deux transmissions de données étant exploitées et enregistrées, les données process étant réduites par l'exploitation et les données process réduites étant transmises à une centrale de contrôle-commande, **caractérisé en ce que** les données process sont réparties lors de l'exploitation en données statiques et en données dynamiques, les données process s'étant modifiées depuis la dernière exploitation réalisée étant classées en tant que données dynamiques, et les données process ne s'étant pas modifiées depuis la dernière exploitation réalisée étant classées en tant que données statiques, et **en ce que** les données statiques sont transmises sous une forme réduite en tant que valeur d'état binaire, qui indique qu'aucune modification de la grandeur process correspondante n'a eu lieu.

2. Procédé selon la revendication 1, **caractérisé en ce que** la transmission des données process réduites est uniquement réalisée en présence de conditions prédéfinies.

3. Procédé d'après l'une des revendications précédentes, **caractérisé en ce que** les données process sont réparties, lors de l'exploitation, en données statiques et en données dynamiques, les données process s'étant modifiées depuis la dernière exploitation réalisée étant classées en tant que données dynamiques.

4. Procédé d'après la revendication 3, **caractérisé en ce que** pour les données dynamiques sont codées des gammes prédéfinies, seul le code de la gamme concernée, lequel contenant la grandeur process, étant transmis à la centrale de contrôle-commande.

5. Procédé d'après la revendication 3 ou 4, **caractérisé en ce que** les données statiques sont transmises en tant que valeur d'état binaire.

6. Procédé d'après la revendication 3, **caractérisé en ce qu'**un mot de données à transmettre est formé à partir des données dynamiques, le mot de données représentant la valeur modifiée de la grandeur process ou la différence entre la nouvelle et l'ancienne valeur de la grandeur process.

7. Procédé d'après l'une des revendications précédentes, **caractérisé en ce que** les conditions prédéfinies pour l'exploitation des données process et/ou pour la réalisation de la transmission des données process réduites sont influençables par un utilisateur.

8. Procédé d'après la revendication 7, **caractérisé en ce que** les conditions prédéfinies en vue de la transmission des données process réduites concernent un intervalle de temps prédéterminé et/ou une heure prédéfinie et/ou l'apparition d'événements prédéfinis.

9. Procédé d'après l'une des revendications précédentes, **caractérisé en ce qu'**un fichier de description d'appareil spécifique est attribué à l'appareil de terrain au moyen de données d'identification, les informations sur l'appareil de terrain étant lues à partir du fichier de description d'appareil.

10. Procédé d'après l'une des revendications précédentes, **caractérisé en ce qu'**Internet est utilisé en tant que plate-forme de communication entre l'appareil de terrain et la centrale de contrôle-commande.

11. Dispositif destiné à la réduction d'une quantité de données process à transmettre, les données process concernant des informations sur l'état de fonctionnement d'un appareil de terrain et/ou des informations sur les variables process déterminées avec l'appareil de terrain et/ou les données d'identification de l'appareil de terrain, **caractérisé en ce qu'**une unité d'exploitation / de commande et une unité de mémoire sont prévues, l'unité d'exploitation / de commande exploitant les données process déterminées et les enregistrant dans l'unité de mémoire dans l'intervalle entre deux transmissions de données, et les transmettant à une centrale de contrôle-commande au moyen d'unités de communication appropriées, et **en ce que** l'appareil de terrain destiné à la réalisation du procédé est conçu d'après l'une des revendications 1 à 10.

12. Dispositif d'après la revendication 11, **caractérisé en ce que** l'unité d'exploitation / de commande et l'unité de mémoire font partie intégrante d'un appareil de terrain.

13. Dispositif d'après la revendication 11 ou 12, **caractérisé en ce que** des conditions prédéfinies influençables par l'utilisateur sont entrées au moyen d'une unité de commande et d'affichage.
